# EUROPÄISCHE PATENTSCHRIFT

(11) **EP 3 104 422 B1**
(45) Veröffentlichungstag und Bekanntmachung des Hinweises auf die Patenterteilung: **28.02.2018**
(21) Anmeldenummer: 16001265.4
(22) Anmeldetag: 03.06.2016
(51) Int. Cl.: H01L 31/167, H01L 31/0304

(54) **OPTOKOPPLER**
OPTOCOUPLER
OPTOCOUPLEUR

(30) Priorität: 12.06.2015 DE 102015007326
(43) Veröffentlichungstag der Anmeldung: 14.12.2016
(73) Patentinhaber: AZUR SPACE Solar Power GmbH, 74072 Heilbronn (DE)
(72) Erfinder: Guter, Wolfgang, 70190 Stuttgart (DE); Fuhrmann, Daniel, 74081 Heilbronn (DE); Khorenko, Victor, 74196 Neuenstadt a.K. (DE)
(74) Vertreter: Koch Müller Patentanwaltsgesellschaft mbH

(56) Entgegenhaltungen:
- WO-A1-2014/096200
- US-A- 4 354 115
- US-A1- 2006 048 811
- US-A1- 2015 162 478
- VALDIVIA CHRISTOPHER E ET AL: "Five-volt vertically-stacked, single-cell GaAs photonic power converter", PROC. SPIE 9358, PHYSICS, SIMULATION, AND PHOTONIC ENGINEERING OF PHOTOVOLTAIC DEVICES IV, Bd. 9358, 16. März 2015 (2015-03-16), Seiten 93580E-1-93580E-8, XP060049977, DOI: 10.1117/12.2079824 ISBN: 978-1-62841-730-2
- SCHUBERT J ET AL: "High-Voltage GaAs Photovoltaic Laser Power Converters", IEEE TRANSACTIONS ON ELECTRON DEVICES, IEEE SERVICE CENTER, PISACATAWAY, NJ, US, Bd. 56, Nr. 2, 28. Januar 2009 (2009-01-28), Seiten 170-175, XP011241423, ISSN: 0018-9383, DOI: 10.1109/TED.2008.2010603

## Beschreibung

Die Erfindung betrifft einen Optokoppler.

Optokoppler sind hinlänglich bekannt. Einfache Optokoppler weisen einen Sendebaustein und einen Empfängerbaustein auf, wobei die beiden Bausteine galvanisch getrennt, jedoch optisch gekoppelt sind. Derartige Bauelemente sind aus der US 4 996 577 bekannt. Auch aus der US 2006/0048811 A1. der US 8 350 208 B1, WO 2013/067969 A1, der US 2015 / 162 478 A1, der WO 2014 096 200 A1 und der US 4 354 115 A sind optische Bauelemente bekannt.

Ferner sind aus der US 4 127 862, der US 6 239 354 B1, der DE 10 2010 001 420 A1, aus Nader M. Kalkhoran, et al, "Cobalt disilicide intercell ohmic contacts for multijunction photovoltaic energy converters", Appl. Phys. Lett. 64, 1980 (1994) und aus A. Bett et al, "III-V Solar cells under monochromatic illumination", Photovoltaic Specialists Conference, 2008, PVSC '08. 33rd IEEE, Seite 1-5, ISBN:978-1-4244-1640-0 sind skalierbare Spannungsquellen oder auch Solarzellen aus III-V Materialien bekannt. Aus Valdiva C. et al: "Five-Volt vertically-stacked, single-cell GaAs photonic power converter", Proc. Spie 9358, Physics, Simulation, and Photonic Engineering of Photovoltaic Devices, Bd. 9358, 16. März 2015, Seiten 93580E1-93580E-8, ISBN: 978-1-62841-730-2 ist ein optischer Power Umsetzer bekannt.

Vor diesem Hintergrund besteht die Aufgabe der Erfindung darin, eine Vorrichtung anzugeben, die den Stand der Technik weiterbildet.

Die Aufgabe wird durch einen Optokoppler mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Optokoppler, aufweisend einen Senderbaustein und einen Empfängerbaustein bereitgestellt, wobei der Senderbaustein und der Empfängerbaustein voneinander galvanisch getrennt und miteinander optisch gekoppelt sind und die beiden Bausteine in einem gemeinsamen Gehäuse integriert sind, und der Empfängerbaustein eine Spannungsquelle umfasst, wobei die Spannungsquelle eine Anzahl N zueinander in Serie geschaltete als Halbleiterdioden ausgebildete Teilspannungsquellen umfasst, wobei jede der Teilspannungsquellen eine Halbleiterdiode mit einem p-n Übergang aufweist, und jede Halbleiterdiode eine p-dotierte p-Absorptionsschicht aufweist, wobei die p-Absorptionsschicht von einer p-dotierten Passivierungsschicht mit einer größeren Bandlücke als die Bandlücke der p-Absorptionsschicht passiviert ist und die Halbleiterdiode eine n-Absorptionsschicht aufweist, wobei die n-Absorptionsschicht von einer n-dotierten Passivierungsschicht mit einer größeren Bandlücke als die Bandlücke der n-Absorptionsschicht passiviert ist, und die Teilquellenspannungen der einzelnen Teilspannungsquellen zueinander eine Abweichung kleiner als 20% aufweisen, und zwischen jeweils zwei aufeinanderfolgenden Teilspannungsquellen eine Tunneldiode ausgebildet ist, wobei die Tunneldiode mehrere Halbleiterschichten mit einer höheren Bandlücke als die Bandlücke der p / n-Absorptionsschichten aufweist und die Halbleiterschichten mit der höheren Bandlücke jeweils aus einem Material mit geänderter Stöchiometrie und /oder anderer Elementzusammensetzung als die p / n -Absorptionsschichten der Halbleiterdiode bestehen, und die Teilspannungsquellen und die Tunneldioden zusammen monolithisch integriert sind, und gemeinsam einen ersten Stapel mit einer Oberseite und einer Unterseite ausbilden, und die Anzahl N der Teilspannungsquellen größer gleich drei ist, und das Licht an der Oberseite auf den ersten Stapel auftrifft und die Größe der Beleuchtungsfläche an der Stapeloberseite im Wesentlichen der Größe der Fläche des ersten Stapels an der Oberseite ist, und der erste Stapel eine Gesamtdicke kleiner als 12µm aufweist, und bei 300 K der erste Stapel eine Quellenspannung von größer als 3 Volt aufweist, sofern der erste Stapel mit einem Photonenstrom bestrahlt ist, und wobei in Lichteinfallsrichtung von der Oberseite des Stapels hin zu der Unterseite des ersten Stapels die Gesamtdicke der p und n - Absorptionsschichten einer Halbleiterdiode von der obersten Diode hin zu der untersten Diode zunimmt und die Spannungsquelle in der Nähe der Unterseite der Stapel einen umlaufenden, absatzförmigen Rand aufweist.

Es sei angemerkt, dass mit dem Ausdruck wesentlich in Zusammenhang des Vergleichs der Beleuchtungsfläche an der Stapeloberseite mit der Größe der Fläche des ersten Stapels an der Oberseite verstanden wird, einen Unterschied in der Fläche insbesondere kleiner als 20% oder vorzugsweise kleiner als 10% oder vorzugsweise kleiner als 5% oder höchst vorzugsweise die beiden Flächen gleich sind.

Auch sei angemerkt, dass mit dem Ausdruck "Licht" zur Bestrahlung der Stapeloberseite, ein Licht verstanden wird, welches ein Spektrum an Wellenlängen in dem Bereich der Absorption der Absorptionsschichten aufweist. Es versteht sich, dass auch ein monochromatisches Licht, welches eine bestimmte d.h. absorbierende Wellenlänge aufweist, also eine Wellenlänge in dem Bereich der Absorption der Absorptionsschichten, geeignet ist.

Es versteht sich, dass sofern die Photonenemission in dem Sendebaustein einer Modulation unterliegt, die Modulation eine Wechselspannung verursacht, anders ausgedrückt, die Höhe der Quellenspannung verändert sich mit der Zeit. Des Weiteren sei angemerkt, dass vorzugsweise die gesamte Oberseite des ersten Stapels d.h. die gesamte oder nahezu die gesamte Oberfläche mit Licht einer bestimmten Wellenlänge bestrahlt wird.

Es versteht sich des Weiteren, dass unter der Bezeichnung Licht mit einer bestimmten Wellenlänge, insbesondere das Licht einer LED gemeint ist, und hierbei das Emissionsspektrum im Allgemeinen Gauß förmig ist und beispielsweise bei einer typischen 850 nm-LED eine Halbwertsbreite von 20-30 nm aufweist. Auch versteht es sich, dass die Wellenlänge des Lichts wenigstens größer oder gleich der Bandlückenenergie der Absorptionsschichten der Halbleiterdioden ist.

Es sei angemerkt, dass eingehende Untersuchungen in überraschender Weise zeigten, dass im Unterschied zu dem Stand der Technik sich in vorteilhafter Weise mit dem vorliegenden monolithischen Stapelansatz Quellenspannungen oberhalb von 3V ergeben.

Es versteht sich, dass die Anzahl N der Teilspannungsquellen vorzugsweise unterhalb zehn liegt und dass sich die Höhe der Quellenspannung des ersten Stapels vorwiegend aus der Addition der Teilquellenspannungen bestimmt ist. Ein Vorteil der erfindungsgemäßen Vorrichtung ist es, dass sich durch die Hintereinanderschaltung von einer Vielzahl von Teilspannungsquellen eine Spannungsquelle mit Spannungswerten auch oberhalb von vier oder mehr Volt realisieren lässt und mittels eines monolithisch integrierten Aufbau eine einfache und kostengünstige sowie eine zuverlässige Spannungsquelle herstellen lässt. Ein weiterer Vorteil ist, dass mittels der stapelförmigen Anordnung im Vergleich zu der bisherigen lateralen Anordnung mit Siliziumdioden eine große Flächeneinsparung ergibt. Insbesondere muss von der Sendediode oder der Lichtquelle nur die wesentlich kleinere Empfangsfläche des ersten Stapels des Empfängerbausteins beleuchtet werden.

Bevorzugt ist, wenn die Anzahl N der Teilspannungsquellen größer gleich drei ist und der erste Stapel bei 300 K eine Quellenspannung von größer als 3 Volt aufweist, sofern der erste Stapel mit einem Photonenstrom mit einer bestimmten Wellenlänge bestrahlt ist.

In einer Weiterbildung weicht die Quellenspannung der einzelnen Teilspannungsquellen untereinander weniger als 10% ab. Hierdurch wird die Einsetzbarkeit als skalierbare Spannungsquelle insbesondere als Referenzspannungsquelle wesentlich verbessert. Es versteht sich, dass sich der Begriff der "Skalierbarkeit" auf die Höhe der Quellenspannung des gesamten Stapels bezieht.

In einer anderen Weiterbildung weisen die Halbleiterdioden jeweils das gleiche Halbleitermaterial auf, wobei hierbei das Halbleitermaterial der Dioden die gleiche kristalline Zusammensetzung aufweist und vorzugsweise die Stöchiometrie nahezu oder vorzugsweise genau gleich ist. Auch ist es vorteilhaft, den ersten Stapel auf einem Substrat anzuordnen. In einer Ausführungsform besteht das Halbleitermaterial und / oder das Substrat aus III-V Materialien. Insbesondere ist bevorzugt, dass das Substrat Germanium oder Galliumarsenid umfasst und / oder die Halbleiterschichten auf dem Substrat Arsen und / oder Phosphor aufweisen. Anders ausgedrückt umfassen die Halbleiterschichten As-haltige Schichten und P -haltige Schichten, d.h. Schichten aus GaAs oder AlGaAs oder InGaAs als Beispiele für Arsenid-Schichten und InGaP als ein Beispiel für Phosphid-Schichten.

Es ist bevorzugt, auf der Unterseite des ersten Stapels einen zweiten Spannungsanschluss auszubilden und insbesondere, dass der zweite Spannungsanschluss durch das Substrat ausgebildet ist.

In einer anderen Ausführungsform bestehen die Halbleiterdioden aus dem gleichen Material wie das Substrat. Ein Vorteil ist, dass sich dann insbesondere die Ausdehnungskoeffizienten der beiden Teile gleichen. Es ist vorteilhaft, wenn die Halbleiterdioden grundsätzlich aus einem III-V Material bestehen. Insbesondere ist es vorteilhaft, wenn die Halbleiterdioden jeweils das gleiche Halbleitermaterial aufweisen. Insbesondere ist es bevorzugt, GaAs zu verwenden.

In einer bevorzugten Ausführungsform ist auf der Oberseite des ersten Stapels ein erster Spannungsanschluss als ein umlaufender Metallkontakt in der Nähe des Randes oder als einzelne Kontaktfläche an dem Rand ausgebildet.

Des Weiteren ist es bevorzugt, wenn der erste Stapel eine Grundfläche kleiner als 2 mm² oder kleiner als 1 mm² aufweist. Untersuchungen haben gezeigt, dass es vorteilhaft ist, die Grundfläche viereckig auszubilden. Vorzugsweise ist die Grundfläche des Stapels quadratisch ausgebildet.

Weitere Untersuchungen haben gezeigt, dass um noch höhere Spannungen zu erzielen es vorteilhaft ist, einen zweiten Stapel auszubilden und die beiden Stapel miteinander in Serie zu verschalten, so dass sich die Quellenspannung des ersten Stapels und die Quellenspannung des zweiten Stapels addieren. Vorzugsweise sind der erste Stapel und der zweite Stapel nebeneinander auf einem gemeinsamen Träger angeordnet.

In einer Weiterbildung weicht die Quellenspannung des ersten Stapels von der Quellenspannung des zweiten Stapels um weniger als 15 % ab. Untersuchungen haben gezeigt, dass es vorteilhaft ist, in dem Gehäuse eine Auswerteschaltung zu integrieren und wenn die Spannungsquelle in einer elektrischen Wirkverbindung mit der Auswerteschaltung steht. In einer bevorzugten Ausführung umfasst der Empfängerbaustein einen integrierten Halbleiterspiegel, wobei der Halbleiterspiegel vorzugsweise monolithisch höchst vorzugsweise in jedem Stapel integriert ist.

Des Weiteren ist es bevorzugt, dass unterhalb der untersten Halbleiterdiode des Stapels ein Halbleiterspiegel ausgebildet ist. Untersuchungen haben gezeigt, dass sich eine Vielzahl von Stapeln nebeneinander auf einem Halbleiterwafer oder Halbleitersubstratscheibe ausbilden lassen, indem nach der ganzflächigen, vorzugsweise epitaktischen Herstellung der Schichten, eine sogenannte Mesaätzung durchgeführt wird. Hierzu wird mittels eines Maskenprozesses eine Lackmaske erzeugt und anschließend vorzugsweise eine naßchemische Ätzung zur Erzeugung von Mesa-Gräben durchgeführt. Die Mesaätzung stoppt vorzugsweise in dem Substrat oder auf dem Substrat.

In einer Ausführungsform ist zwischen der p-Absorptionsschicht und der n-Absorptionsschicht der jeweiligen Diode eine intrinsische Schicht ausgebildet. Hierbei wird unter einer intrinsischen Schicht eine Halbleiterschicht mit einer Dotierung unterhalb 1E16 1/cm², vorzugsweise kleiner als 5E15 1/cm², höchst vorzugsweise kleiner als 1,5 E15 1/ cm² verstanden.

In einer Weiterbildung ist es bevorzugt, dass jeder Stapel in der Nähe der Unterseite einen umlaufenden, absatzförmigen Rand aufweist, wobei bei zwei unmittelbar benachbarten Stapeln an den Außenseiten des Stapelgebildes der umlaufende Rand als ein gemeinsamer umlaufender Rand ausgebildet ist, so dass die Spannungsquelle einen umlaufenden Rand aufweist.

Vorzugsweise ist der Rand stufenförmig oder als Stufe ausgebildet. Hierbei weist die Oberfläche des Randes bzw. der Stufe vorzugsweise größtenteils eine plane Fläche auf, wobei die Normale der Oberfläche des Randes bzw. der Stufe parallel oder nahezu parallel zu der Normalen der Oberfläche des ersten Stapels oder der Normalen der Oberflächen der jeweiligen Stapel ausgebildet ist. Es sei angemerkt dass die Seitenfläche des Randes oder der Stufe überwiegend oder genau senkrecht zu der Oberfläche des Randes bzw. der Stufe ausgebildet ist.

Die Kante des Randes oder der Stufe ist wenigstens 5 µm und maximal 500 µm jeweils von jeder der vier Seitenflächen des ersten Stapels oder jeweils von den Seitenflächen der mehreren Stapeln entfernt. Vorzugsweise liegt der Entfernungsbereich jeweils der Kante zu der unmittelbar angrenzenden Seitenfläche zwischen 10 µm und 300 µm. Insbesondere liegt der Entfernungsbereich zwischen 50 µm und 250 µm.

Vorzugsweise sind die Seitenflächen des ersten Stapels und insbesondere alle Seitenflächen der Stapel plan und insbesondere senkrecht oder nahezu senkrecht ausgebildet. Insbesondere liegen die Normalen auf Seitenflächen im Vergleich zu den Normalen der angrenzenden Randflächen oder den Normalen der Stapeloberflächen in einen Winkelbereich zwischen 80° und 110°, d.h. die Normalen einer Seitenfläche und der unmittelbar angrenzenden Randfläche sind zueinander im Wesentlichen Orthogonal. Vorzugsweise liegt der Winkelbereich zwischen 85° und 105°.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine erste erfindungsgemäße Ausführungsform eines Optokopplers mit skalierbarer Spannungsquelle mit einem Stapel,
- Figur 2: eine zweite Ausführungsform eines Optokopplers mit einer skalierbaren Spannungsquelle mit mehreren Stapeln.
- Figur 3: eine Ausführungsform mit insgesamt fünf Dioden mit unterschiedlicher Dicke des Absorptionsgebiets,
- Figur 4: einen Stapel mit einer umlaufenden absatzförmigen Stufe,
- Figur 5a: eine Querschnittsansicht auf eine vertikale Anordnung von Sende- um Empfängerbaustein,
- Figur 5b: eine Querschnittsansicht auf eine laterale Anordnung von Sende- um Empfängerbaustein.

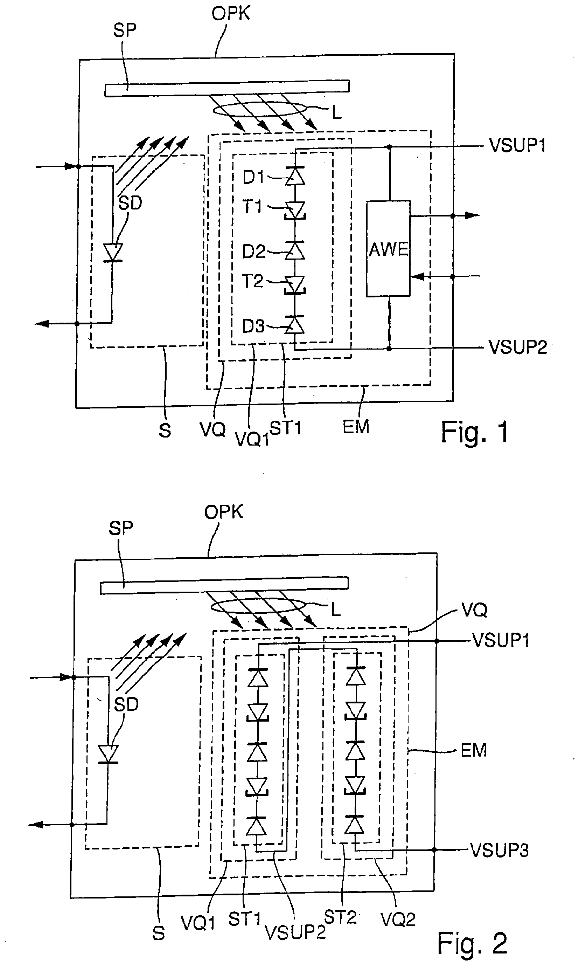

Die Abbildung der Figur 1 zeigt eine schematische Ansicht einer ersten Ausführungsform, aufweisend einen Optokoppler OPK mit einer Senderbaustein S mit einer Sendediode SD und einer Empfängerbaustein EM. Die Empfängerbaustein EM weist eine skalierbare Spannungsquelle VQ und eine Auswerteeinheit AWE auf. Es versteht sich, dass sich der Begriff der "Skalierbarkeit" auf die Höhe der Quellenspannung des gesamten Stapels bezieht. Mittels eines Spiegels SP ist das Licht L der Sendediode SD auf die Oberfläche der skalierbare Spannungsquelle VQ geleitet. Es versteht sich, dass der Optokoppler OPK vorliegend gehäust ist, d.h. die genannten Bauelemente sind in dem gemeinsamen Gehäuse integriert.

Die Spannungsquelle VQ weist einen ersten Stapel ST1 mit einer Oberseite und einer Unterseite mit einer Anzahl N gleich drei Dioden auf. Der erste Stapel ST1 weist eine Serienschaltung aus einer ersten Diode D1 und einer ersten Tunneldiode T1 und einer zweiten Diode D2 und einer zweiten Tunneldiode T2 und einer dritten Diode D3 auf. An der Oberseite des ersten Stapel ST1 ist ein erster Spannungsanschluss VSUP1 und an der Unterseite des ersten Stapel ST1 ein zweiter Spannungsanschluss VSUP2 ausgebildet. Die Quellenspannung setzt sich vorliegend aus den Teilspannungen der einzelnen Diode D1 bis D3 zusammen. Hierzu ist der erste Stapel ST1 einem Photonenstrom L von der Sendediode SD ausgesetzt. Sofern die Sendediode SD einen modulierten Photonenstrom aussendet, wird in dem ersten Stapel ST1 die Quellenspannung VQ1 des ersten Stapels ST1 ebenfalls moduliert.

Der erste Stapel ST1, umfassend die Dioden D1 bis D3 und die Tunneldioden T1 und T2, ist als monolithisch ausgebildeter Block ausgeführt. Die Auswerteeinheit AWE umfasst eine integrierte Schaltung - nicht dargestellt. Der Sendebaustein S und der Empfangsbaustein EM weisen jeweils zwei voneinander galvanisch getrennte Anschlüsse auf.

In der Abbildung der Figur 2 ist eine weitere Ausführungsform des Optokopplers der Figur 1 mit einer vorteilhaften Aneinanderreihung von dem ersten Stapel ST1 und einem zweiten Stapel ST2 ausgebildet. Im Folgenden werden nur die Unterschiede zu der Abbildung der Figur 1 erläutert. Der zweite Stapel ST2 weist wie der erste Stapel ST1 eine Serienschaltung aus drei Dioden mit dazwischen ausgebildeten Tunneldioden auf. Beide Stapel ST1 und ST2 sind miteinander in Serie verschaltet, sodass sich die Quellenspannung VQ1 des ersten Stapels ST1 und die Quellenspannung VQ2 des zweiten Stapel ST2 addieren, sofern die beiden Stapel ST1 und ST2 dem Photonenstrom L der Sendediode SD ausgesetzt sind. Vorliegend weist der Empfangsbaustein EM keine Auswerteschaltung auf, sodass der erste Spannungsanschluss VSUP1 und der zweite Spannungsanschluss VSUP3 unmittelbar nach außen geführt sind.

In einer nicht dargestellten Ausführungsform weisen die beiden Stapel ST1 und ST2 zueinander eine unterschiedliche Anzahl von jeweils in einer Serienschaltung verbundenen Dioden auf. In einer anderen nicht dargestellten Ausführungsform weist wenigstens der erste Stapel ST1 und / oder der zweite Stapel ST2 mehr als drei in einer Serienschaltung verbundene Dioden auf. Hierdurch lässt sich die Spannungshöhe der Spannungsquelle VQ skalieren. Vorzugsweise liegt die Anzahl N in einem Bereich zwischen vier und acht.

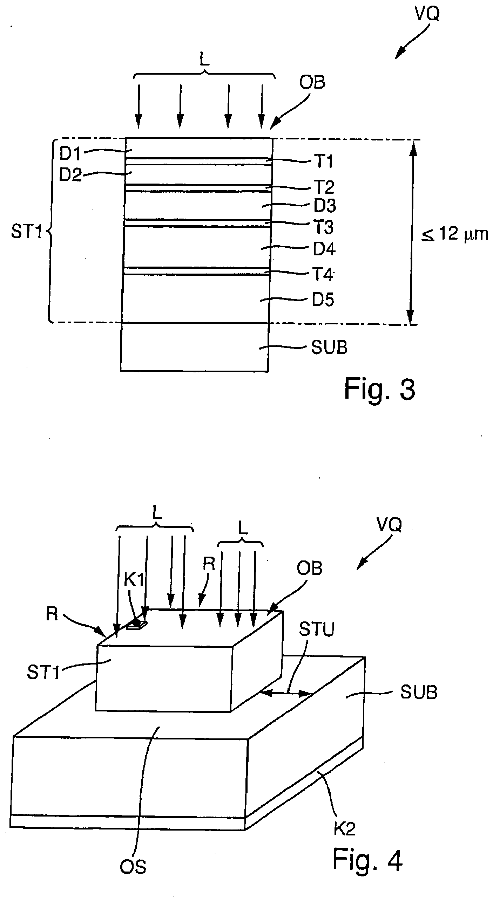

In der Abbildung der Figur 3 ist eine Ausführungsform einer vorteilhaften Aneinanderreihung von Halbleiterschichten zu dem ersten Stapel ST1 dargestellt. Im Folgenden werden nur die Unterschiede zu der Abbildung der Figur 1 erläutert. Der erste Stapel ST1 umfasst insgesamt fünf in Reihe geschaltete als Dioden D1 bis D5 ausgebildete Teüspannungsquellen. Auf die Oberfläche OB der ersten Diode D1 trifft das Licht L auf. Die Oberfläche OB wird nahezu oder vollständig ausgeleuchtet. Zwischen zwei aufeinanderfolgenden Dioden D1-D5 ist jeweils eine Tunneldiode T1-T4 ausgebildet. Mit zunehmender Entfernung der einzelnen Diode D1 bis D5 von der Oberfläche OB steigt die Dicke des Absorptionsgebiets, so dass die unterste Diode D5 das dickste Absorptionsgebiet aufweist. Insgesamt beträgt die Gesamtdicke des ersten Stapels ST1 kleiner gleich 12 µm. Unterhalb der untersten Diode D5 ist ein Substrat SUB ausgebildet.

In der Abbildung der Figur 4 ist eine Ausführungsform einer vorteilhaften Aneinanderreihung von Halbleiterschichten zu dem ersten Stapel ST1 dargestellt mit einer umlaufenden absatzförmigen Stufe. Im Folgenden werden nur die Unterschiede zu der Abbildung der Figur 3 erläutert. Auf der Oberfläche OB des ersten Stapels ST1 ist an dem Rand R ein erster metallischer Anschlusskontakt K1 ausgebildet. Der erste Anschlusskontakt K1 ist mit dem ersten Spannungsanschluss VSUP1 verschaltet - nicht dargestellt. Das Substrat SUB weist eine Oberseite OS auf, wobei die Oberseite OS des Substrats SUB stoffschlüssig mit der untersten, d.h. der fünften Diode D5 verbunden ist. Hierbei versteht es sich, dass auf dem Substrat eine dünne Nukleationsschicht und eine Pufferschicht epitaktisch erzeugt wird, bevor auf dem Substrat die fünfte Diode angeordnet wird und stoffschlüssig mit der Oberseite OS des Substrats verbunden wird. Die Oberseite OS des Substrats SUB weist eine größere Oberfläche als die Fläche an der Unterseite des ersten Stapels ST1 auf. Hierdurch bildet sich eine umlaufende Stufe STU aus. Der Rand der Stufe STU ist von der unmittelbar angrenzenden Seitenfläche des ersten Stapels ST1 der Stufe um mehr als 5µm und weniger als 500µm entfernt, dargestellt als Länge des Referenzzeichens STU. An der Unterseite des Substrats SUB ist ein zweiter ganzflächiger metallischer Kontakt K2 ausgebildet. Der zweite Anschlusskontakt K2 ist mit dem zweiten Spannungsanschluss VSUP2 verschaltet - nicht dargestellt.

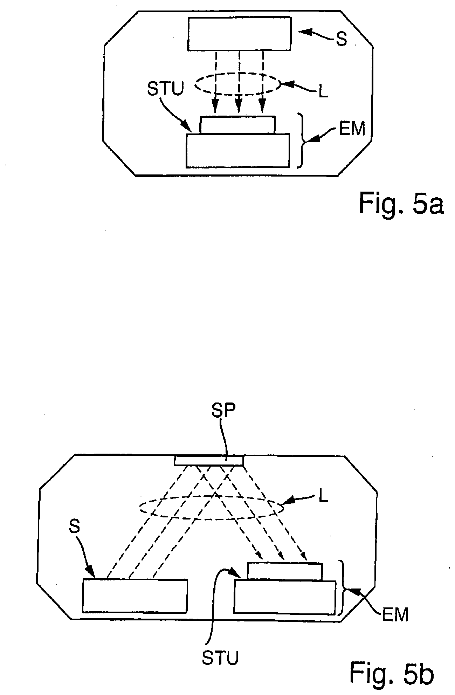

In den Abbildungen der Figur 5a und 5b eine Querschnittsansicht auf eine vertikale Anordnung von Senderbaustein S und Empfängerbaustein EM und eine Querschnittsansicht auf eine laterale Anordnung von Senderbaustein S und Empfängerbaustein EM auf, wobei der Senderbaustein S mit jeweils dem ersten Stapel ST1 eine umlaufenden absatzförmige Stufe umfasst. Im Folgenden werden nur die Unterschiede zu den Ausführungsformen, dargestellt in den vorangegangenen Figuren, erläutert. Es zeigt sich, dass bei einer vertikalen Anordnung ein Spiegel SP sich erübrigt. Es versteht sich, dass mit den aufgezeigten parallelen Lichtstrahlen des Lichts L nur der prinzipielle Verlauf des Lichtes L aufgezeigt werden soll. Im Allgemeinen weist, das Licht des Senderbausteins ein divergentes Lichtbündel auf.

## Patentansprüche

1. Optokoppler (OPK), aufweisend
einen Senderbaustein (S) und einen Empfängerbaustein (EM), wobei der Senderbaustein (S) und der Empfängerbaustein (EM) von einander galvanisch getrennt und miteinander optisch gekoppelt sind und die beiden Bausteine (S, EM) in einem gemeinsam Gehäuse integriert sind, und
der Empfängerbaustein (EM) aufweist
- eine Anzahl N zueinander in Serie geschalteter als Halbleiterdioden ausgebildete Teilspannungsquellen, wobei jede der Teilspannungsquellen eine Halbleiterdiode (D1, D2, D3, D4, D5) mit einen p-n Übergang aufweist, und
die Halbleiterdiode (D1, D2, D3, D4, D5) eine p-dotierte p-Absorptionsschicht aufweist, und
die Halbleiterdiode (D1, D2, D3, D4, D5) eine n-dotierte n-Absorptionsschicht aufweist, **dadurch gekennzeichnet, dass**
die n-Absorptionsschicht von einer n-dotierten Passivierungsschicht mit einer größeren Bandlücke als die Bandlücke der n-Absorptionsschicht passiviert ist, und
die Teilquellenspannungen der einzelnen Teilspannungsquellen zueinander eine Abweichung kleiner als 20% aufweisen, und zwischen jeweils zwei aufeinanderfolgenden Teilspannungsquellen eine Tunneldiode (T1, T2, T3, T4) ausgebildet ist, wobei
die Tunneldiode (T1, T2, T3, T4) mehrere Halbleiterschichten mit einer höheren Bandlücke als die Bandlücke der p / n-Absorptionsschichten aufweist und
die Halbleiterschichten mit der höheren Bandlücke jeweils aus einem Material mit geänderter Stöchiometrie oder anderer Elementzusammensetzung als die p / n -Absorptionsschichten der Halbleiterdiode (D1, D2, D3, D4, D5) oder aus einem Material mit geänderter Stöchiometrie und anderer Elementzusammensetzung als die p /n - Absorptionsschichten bestehen, und
- die Teilspannungsquellen und die Tunneldioden (T1, T2, T3, T4) zusammen monolithisch integriert sind, und gemeinsam einen ersten Stapel (ST1) mit einer Oberseite und einer Unterseite ausbilden, und die Anzahl N der Teilspannungsquellen größer gleich drei ist, und
- auf den ersten Stapel (ST1) Licht (L) an der Oberseite auf die Oberfläche (OB) des ersten Stapels (ST1) auftrifft und die Größe der beleuchteten Oberfläche (OB) an der Stapeloberseite im Wesentlichen oder wenigstens der Größe der Fläche des ersten Stapels (ST1) an der Oberseite entspricht, und der erste Stapel (ST1) eine Gesamtdicke kleiner als 12µm aufweist, und
- bei 300 K der erste Stapel (ST1) eine Quellenspannung (VQ1) von größer als 3 Volt aufweist, sofern der erste Stapel (ST1) mit Licht (L) bestrahlt ist, und wobei in Lichteinfallsrichtung von der Oberseite des ersten Stapels (ST1) hin zu der Unterseite des Stapels die Gesamtdicke der p und n -Absorptionsschichten einer Halbleiterdiode von der obersten Diode (D1) hin zu der untersten Diode (D3 - D5) zunimmt und jede p-Absorptionsschicht der Halbleiterdiode (D1, D2, D3, D4) von einer p-dotierten Passivierungsschicht mit einer größeren Bandlücke als die Bandlücke der p-Absorptionsschicht passiviert ist und
die Spannungsquelle in der Nähe der Unterseite des Stapels einen umlaufenden, absatzförmigen Rand aufweist.

2. Optokoppler (OPK) nach Anspruch 1, **dadurch gekennzeichnet, dass** die Teilquellenspannungen der Teilspannungsquellen des Empfängerbausteins (EM) zueinander einer Abweichung kleiner als 10% aufweisen.

3. Optokoppler (OPK) nach Anspruch 1 oder Anspruch 2, **dadurch gekennzeichnet, dass** die Halbleiterdioden (D1, D2, D3, D4, D5) des Empfängerbausteins (EM) jeweils das gleiche Halbleitermaterial aufweisen.

4. Optokoppler (OPK) nach einem oder mehreren der vorangegangenen Ansprüche, **dadurch gekennzeichnet, dass** der erste Stapel (ST1) auf einem Substrat (SUB) angeordnet ist und das Substrat (SUB) ein Halbleitermaterial umfasst.

5. Optokoppler (OPK) nach einem oder mehreren der vorangegangenen Ansprüche, **dadurch gekennzeichnet, dass** der erste Stapel (ST1) eine Grundfläche kleiner als 2 mm² oder kleiner als 1 mm² aufweist.

6. Optokoppler (OPK) nach einem der vorangegangenen Ansprüche, **dadurch gekennzeichnet, dass** auf der Oberseite des ersten Stapels (ST1) des Empfängerbausteins (EM) ein erster Spannungsanschluss (VSUP) als ein umlaufender Metallkontakt in der Nähe des Randes oder als eine einzelne Kontaktfläche (K1) an dem Rand (R) ausgebildet ist.

7. Optokoppler (OPK) nach einem der vorangegangenen Ansprüche, **dadurch gekennzeichnet, dass** auf der Unterseite des ersten Stapels (ST1) des Empfängerbausteins (EM) ein zweiter Spannungsanschluss (VSUP2) ausgebildet ist.

8. Optokoppler (OPK) nach Anspruch 7, **dadurch gekennzeichnet, dass** der zweite Spannungsanschluss (VSUP2) des Empfängerbausteins (EM) durch das Substrat ausgebildet ist.

9. Optokoppler (OPK) nach einem oder mehreren der vorangegangenen Ansprüche, **dadurch gekennzeichnet, dass** im Empfängerbaustein (EM) ein zweiter Stapel (ST2) ausgebildet ist und der erste Stapel (ST1) und der zweite Stapel (ST2) nebeneinander auf einem gemeinsamen Träger angeordnet sind und die beiden Stapel (ST1, ST2) miteinander in Serie verschaltet sind, so dass sich die Quellenspannung (VQ1) des ersten Stapels (ST1) und die Quellenspannung (VQ2) des zweiten Stapels (ST2) addieren.

10. Optokoppler (OPK) nach einem oder mehreren der vorangegangenen Ansprüche, **dadurch gekennzeichnet, dass** zwischen der p-Absorptionsschicht und der n-Absorptionsschicht der jeweiligen Diode des Empfängerbausteins (EM) eine intrinsische Schicht ausgebildet ist.

11. Optokoppler (OPK) nach einem oder mehreren der vorangegangenen Ansprüche, **dadurch gekennzeichnet, dass** das Halbleitermaterial oder das Substrat des Empfängerbausteins (EM) oder sowohl das Halbleitermaterial als auch das Substrat des Empfängerbausteins aus III-V Materialien bestehen.

12. Optokoppler (OPK) nach einem der Ansprüche 1- 10, **dadurch gekennzeichnet, dass** das Substrat des Empfängerbausteins (EM) Germanium oder Galliumarsenid umfasst.

13. Optokoppler (OPK) nach einem der vorangegangenen Ansprüche, **dadurch gekennzeichnet, dass** in dem Gehäuse eine Auswerteschaltung (AWE) integriert ist und die Spannungsquelle in einer elektrischen Wirkverbindung mit der Auswerteschaltung (AWE) steht.

14. Optokoppler (OPK) nach einem oder mehreren der vorangegangenen Ansprüche, **dadurch gekennzeichnet, dass** unterhalb der untersten Halbleiterdiode des Stapels (ST1) des Empfängerbausteins (EM) ein Halbleiterspiegel ausgebildet ist.

15. Optokoppler (OPK) nach einem oder mehreren der vorangegangenen Ansprüche, **dadurch gekennzeichnet, dass** die Halbleiterschichten des Stapels (ST1) des Empfängerbausteins (EM) gleichzeitig Arsenid-haltige Schichten und Phosphid-haltige Schichten umfassen.

16. Optokoppler (OPK) nach einem oder mehreren der vorangegangenen Ansprüche, **dadurch gekennzeichnet, dass** die Kante des Randes wenigstens 5 µm und maximal 500 µm von der unmittelbar angrenzenden Seitenfläche der Stapel entfernt ist.

## Claims

1. Optocoupler (OPK) comprising
a transmitter unit (S) and a receiver unit (EM), wherein the transmitter unit (S) and the receiver unit (EM) are electrically isolated from one another and optically coupled together and the two units (S, EM) are integrated in a common housing, and the receiver unit (EM) comprises
- a number N of part voltage sources connected together in series and constructed as semiconductor diodes, wherein each of the part voltage sources comprises a semiconductor diode (D1, D2, D3, D4, D5) with a p-n transition, and the semiconductor diode (D1, D2, D3, D4, D5) has a p-doped p absorption layer and
the semiconductor diode (D1, D2, D3, D4, D5) has an n-doped n absorption layer, **characterised in that**
the n absorption layer is passivated by an n-doped passivation layer with a greater band gap than the band gap of the n absorption layer and
the part source voltages of the individual part voltage sources have a difference of less than 20% relative to one another and
a tunnel diode (T1, T2, T3, T4) is formed between each two successive part voltage sources, wherein
the tunnel diode (T1, T2, T3, T4) comprises several semiconductor layers with a higher band gap than the band gap of the p/n absorption layers and
the semiconductor layers with the higher band gap each consist of a material with changed stoichiometry or different element composition relative to the p/n absorption layers of the semiconductor diode (D1, D2, D3, D4, D5) or of a material with changed stoichiometry and different element composition relative to the p/n absorption layers and
- the part voltage sources and the tunnel diodes (T1, T2, T3, T4) are monolithically integrated together and together form a first stack (ST1) with an upper side and a lower side and the number N of the part voltage sources is greater than or equal to three and
- at the first stack (ST1) light (L) is incident at the upper side on the surface (OB) of the first stack (ST1) and the size of the illuminated surface (OB) at the stack upper side corresponds substantially or at least with the size of the area of the first stack (ST1) at the upper side and
the first stack (ST1) has an overall thickness of less than 12 µm, and
- at 300 K the first stack (ST1) has a source voltage (VQ1) of more than 3 volts insofar as the first stack (ST1) is irradiated with light (L), and wherein in the direction of light incidence from the upper side of the first stack (ST1) towards the lower side of the stack the overall thickness of the p and n absorption layers of a semiconductor diode increases from the uppermost diode (D1) towards the lowermost diode (D3 - D5) and each p absorption layer of the semiconductor diode (D1, D2, D3, D4) is passivated by a p-doped passivation layer with a greater band gap than the band gap of the p absorption layer and
the voltage source in the vicinity of the lower side of the stack has an encircling, projection-shaped edge.

2. Optocoupler (OPK) according to claim 1, **characterised in that** the part source voltages of the part voltage sources of the receiver unit (EM) have a difference from one another of less than 10%.

3. Optocoupler (OPK) according to claim 1 or claim 2, **characterised in that** the semiconductor diodes (D1, D2, D3, D4, D5) of the receiver unit (EM) respectively comprise the same semiconductor material.

4. Optocoupler (OPK) according to one or more of the preceding claims, **characterised in that** the first stack (ST1) is arranged on a substrate (SUB) and the substrate (SUB) comprises a semiconductor material.

5. Optocoupler (OPK) according to one or more of the preceding claims, **characterised in that** the first stack (ST1) has a plan area less than 2 square millimetres or less than 1 square millimetre.

6. Optocoupler (OPK) according to any one of the preceding claims, **characterised in that** a first voltage terminal (VSUP) is formed on the upper side of the first stack (ST1) of the receiver unit (EM) as an encircling metal contact in the vicinity of the edge or as an individual contact surface (K1) at the edge (R).

7. Optocoupler (OPK) according to any one of the preceding claims, **characterised in that** a second voltage terminal (VSUP2) is formed on the lower side of the first stack (ST1) of the receiver unit (EM).

8. Optocoupler (OPK) according to claim 7, **characterised in that** the second voltage terminal (VSUP2) of the receiver unit (EM) is formed by the substrate.

9. Optocoupler (OPK) according to one or more of the preceding claims, **characterised in that** a second stack (ST2) is formed in the receiver unit (EM) and the first stack (ST1) and the second stack (ST2) are arranged adjacent to one another on a common support and the two stacks (ST1, ST2) are connected together in series so that the source voltage (VQ1) of the first stack (ST1) and the source voltage (VQ2) of the second stack (ST2) summate.

10. Optocoupler (OPK) according to one or more of the preceding claims, **characterised in that** an intrinsic layer is formed between the p absorption layer and the n absorption layer of the respective diode of the receiver unit (EM).

11. Optocoupler (OPK) according to one or more of the preceding claims, **characterised in that** the semiconductor material or the substrate of the receiver unit (EM) or both the semiconductor material and the substrate of the receiver unit consists or consist of III-V materials.

12. Optocoupler (OPK) according to any one of claims 1 to 10, **characterised in that** the substrate of the receiver unit (EM) comprises germanium or gallium arsenide.

13. Optocoupler (OPK) according to any one of the preceding claims, **characterised in that** an evaluating circuit (AWE) is integrated in the housing and the voltage source is in electrically operative connection with the evaluating circuit (AWE).

14. Optocoupler (OPK) according to one or more of the preceding claims, **characterised in that** a semiconductor mirror is formed below the lowermost semiconductor diode of the stack (ST1) of the receiver unit (EM).

15. Optocoupler (OPK) according to one or more of the preceding claims, **characterised in that** the semiconductor layers of the stack (ST1) of the receiver unit (EM) comprise, at the same time, layers containing arsenide and layers containing phosphide.

16. Optocoupler (OPK) according to one or more of the preceding claims, **characterised in that** the brink of the edge is spaced at least 5 µm and at most 500 µm from the directly adjoining side surface of the stack.

## Revendications

1. Optocoupleur (OPK), présentant
un module émetteur (S) et un module récepteur (EM), dans lequel le module émetteur (S) et le module récepteur (EM) sont galvaniquement séparés l'un de l'autre et sont couplés optiquement l'un à l'autre et les deux modules (S, EM) sont intégrés dans un boîtier commun, et le module récepteur (EM) présente
- un nombre N de sources de tension partielle montées en série l'une par rapport à l'autre sous forme de diodes à semi-conducteur, dans lequel chacune des sources de tension partielle présente une diode à semi-conducteur (D1, D2, D3, D4, D5) avec une transition p-n, et
la diode à semi-conducteur (D1, D2, D3, D4, D5) présente une couche d'absorption p à dopage p, et
la diode à semi-conducteur (D1, D2, D3, D4, D5) présente une couche d'absorption n à dopage n,
**caractérisé en ce que**
la couche d'absorption n est passivée par une couche de passivation à dopage n avec une bande interdite plus grande que la bande interdite de la couche d'absorption n, et
les tensions de sources partielles des sources de tension partielle individuelles présentent l'une par rapport à l'autre un écart inférieur à 20 %, et
une diode tunnel (T1, T2, T3, T4) est formée entre chaque fois deux sources de tension partielle successives, dans lequel la diode tunnel (T1, T2, T3, T4) présente plusieurs couches semi-conductrices avec une bande interdite plus grande que la bande interdite des couches d'absorption p/n, et
les couches semi-conductrices avec la plus grande bande interdite se composent respectivement d'un matériau présentant une stoechiométrie modifiée ou une autre composition élémentaire que les couches d'absorption p/n de la diode à semi-conducteur (D1, D2, D3, D4, D5) ou d'un matériau présentant une stoechiométrie modifiée et une autre composition élémentaire que les couches d'absorption p/n, et
- les sources de tension partielle et les diodes tunnels (T1, T2, T3, T4) sont intégrées ensemble de façon monolithique et forment ensemble une première pile (ST1) avec un côté supérieur et un côté inférieur et le nombre N des sources de tension partielle est supérieur ou égal à trois, et
- sur la première pile (ST1) de la lumière (L) arrive sur le côté supérieur sur la surface (OB) de la première pile (ST1) et la grandeur de la surface éclairée (OB) sur le côté supérieur de la pile correspond essentiellement ou au moins à la grandeur de la face de la première pile (ST1) sur le côté supérieur, et
la première pile (ST1) présente une épaisseur totale inférieure à 12 µm et
- à 300 K la première pile (ST1) présente une tension de source (VQ1) supérieure à 3 volts, dans la mesure où la première pile (ST1) est éclairée avec la lumière (L) et dans lequel, dans la direction d'incidence de la lumière du côté supérieur de la première pile (ST1) au côté inférieur de la pile, l'épaisseur totale des couches d'absorption p et n d'une diode à semi-conducteur augmente de la diode la plus haute (D1) à la diode la plus basse (D3 - D5) et chaque couche d'absorption p de la diode à semi-conducteur (D1, D2, D3, D4) est passivée par une couche de passivation à dopage p présentant une bande interdite plus grande que la bande interdite de la couche d'absorption p et
la source de tension présente à proximité du côté inférieur de la pile un bord périphérique en forme d'épaulement.

2. Optocoupleur (OPK) selon la revendication 1, **caractérisé en ce que** les tensions de source partielles des sources de tension partielle du module récepteur (EM) présentent l'une par rapport à l'autre un écart inférieur à 10 %.

3. Optocoupleur (OPK) selon la revendication 1 ou la revendication 2, **caractérisé en ce que** les diodes à semi-conducteur (D1, D2, D3, D4, D5) du module récepteur (EM) présentent chacune le même matériau semi-conducteur.

4. Optocoupleur (OPK) selon une ou plusieurs des revendications précédentes, **caractérisé en ce que** la première pile (ST1) est disposée sur un substrat (SUB) et le substrat (SUB) comprend un matériau semi-conducteur.

5. Optocoupleur (OPK) selon une ou plusieurs des revendications précédentes, **caractérisé en ce que** la première pile (ST1) présente une surface de base inférieure à 2 mm² ou inférieure à 1 mm².

6. Optocoupleur (OPK) selon l'une quelconque des revendications précédentes, **caractérisé en ce qu'**un premier raccord de tension (VSUP) est formé sur le côté supérieur de la première pile (ST1) du module récepteur (EM) sous forme de contact métallique périphérique à proximité du bord ou sous forme de face de contact individuelle (K1) sur le bord (R).

7. Optocoupleur (OPK) selon l'une quelconque des revendications précédentes, **caractérisé en ce qu'**un deuxième raccord de tension (VSUP2) est formé sur le côté inférieur de la première pile (ST1) du module récepteur (EM).

8. Optocoupleur (OPK) selon la revendication 7, **caractérisé en ce que** le deuxième raccord de tension (VSUP2) du module récepteur (EM) est formé par le substrat.

9. Optocoupleur (OPK) selon une ou plusieurs des revendications précédentes, **caractérisé en ce qu'**une deuxième pile (ST2) est formée dans le module récepteur (EM) et la première pile (ST1) et la deuxième pile (ST2) sont disposées l'une à côté de l'autre sur un support commun et les deux piles (ST1, ST2) sont connectées en série l'une à l'autre, de telle manière que la tension de source (VQ1) de la première pile (ST1) et la tension de source (VQ2) de la deuxième pile (ST2) s'additionnent.

10. Optocoupleur (OPK) selon une ou plusieurs des revendications précédentes, **caractérisé en ce qu'**une couche intrinsèque est formée entre la couche d'absorption p et la couche d'absorption n de la diode respective du module récepteur (EM).

11. Optocoupleur (OPK) selon une ou plusieurs des revendications précédentes, **caractérisé en ce que** le matériau semi-conducteur ou le substrat du module récepteur (EM) ou aussi bien le matériau semi-conducteur que le substrat du module récepteur (EM) se composent de matériaux des groupes III-V.

12. Optocoupleur (OPK) selon l'une quelconque des revendications 1 à 10, **caractérisé en ce que** le substrat du module récepteur (EM) comprend du germanium ou de l'arséniure de gallium.

13. Optocoupleur (OPK) selon l'une quelconque des revendications précédentes, **caractérisé en ce qu'**un circuit d'analyse (AWE) est intégré dans le boîtier et la source de tension est en liaison électrique active avec le circuit d'analyse (AWE).

14. Optocoupleur (OPK) selon une ou plusieurs des revendications précédentes, **caractérisé en ce qu'**un miroir à semi-conducteur est formé en dessous de la diode à semi-conducteur la plus basse de la pile (ST1) du module récepteur (EM).

15. Optocoupleur (OPK) selon une ou plusieurs des revendications précédentes, **caractérisé en ce que** les couches de semi-conducteur de la pile (ST1) du module récepteur (EM) comprennent simultanément des couches contenant de l'arséniure et des couches contenant du phosphure.

16. Optocoupleur (OPK) selon une ou plusieurs des revendications précédentes, **caractérisé en ce que** le côté du bord est éloigné d'au moins 5 µm et au maximum de 500 µm de la face latérale immédiatement adjacente des piles.
